Europäisches Patentamt

(19) European Patent Office    (11) Numéro de publication: **0 027 072**

Office européen des brevets    **B1**

(12)    **FASCICULE DE BREVET EUROPEEN**

(45) Date de publication du fascicule du brevet: **18.05.83**    (51) Int. Cl.³: **H 01 L 31/02, H 01 L 33/00**

(21) Numéro de dépôt: **80401353.0**

(22) Date de dépôt: **23.09.80**

(54) **Procédé de couplage entre une fibre optique et une diode opto-électronique, et tête d'émission ou de réception réalisée par ce procédé.**

(30) Priorité: **05.10.79 FR 7924891**

(43) Date de publication de la demande:
**15.04.81 Bulletin 81/15**

(45) Mention de la délivrance du brevet:
**18.05.83 Bulletin 83/20**

(84) Etats contractants désignés:
**DE GB IT NL**

(56) Documents cités:
**FR - A - 2 354 638**
**US - A - 4 010 483**

(73) Titulaire: **THOMSON-CSF**
**173, Boulevard Haussmann**
**F-75379 Paris Cedex 08 (FR)**

(72) Inventeur: **Henry, Raymond**
**"THOMSON-CSF" - SCPI 173, Bld Haussmann**
**F-75360 Paris Cedex 08 (FR)**
Inventeur: **Bouvet, Jean-Victor**
**"THOMSON-CSF" - SCPI 173, Bld Haussmann**
**F-75360 Paris Cedex 08 (FR)**
Inventeur: **Chapard, Alain**
**"THOMSON-CSF" - SCPI 173, Bld Haussmann**
**F-75360 Paris Cedex 08 (FR)**
Inventeur: **Simon, Jacques**
**"THOMSON-CSF" - SCPI 173, Bld Haussmann**
**F-75360 Paris Cedex 08 (FR)**

(74) Mandataire: **Giraud, Pierre et al,**
**THOMSON-CSF SCPI 173, Bld Haussmann**
**F-75379 Paris Cedex 08 (FR)**

Courier Press, Leamington Spa, England.

## Procédé de couplage entre une fibre optique et une diode opto-électronique, et tête d'émission ou de réception réalisée par ce procédé

L'invention concerne un procédé de couplage entre une fibre optique et une diode photo-réceptrice ou photo-émettrice ainsi qu'une tête opto-électronique réalisé en utilisant un tel procédé.

On sait qu'une tête opto-électronique constitue un point de transition entre une fibre optique et un composant, généralement à semiconducteur, constituant le terminal optique, à la réception ou à l'émission, d'une liaison de télécommunications.

Dans une tête opto-électronique, la fibre optique présente un diamètre généralement très petit, parfois jusqu'à 50 microns; si le composant est une photodiode de réception, les dimensions de la surface photodétectrice sont également très petites. Dans une tête de type classique, la fibre optique est montée dans un porte-fibre dont elle émerge du côté diode, la photodiode étant montée sur une embase qui s'adapte au porte-fibre. Les positionnement respectifs de la fibre et de la diode doivent, en conséquence, être extrêmement précis. Il en résulte que la fabrication de telles têtes est du domaine de la mécanique de précision et que leur coût de production est élevé.

L'invention permet de simplifier le problème de positionnement relatif entre la fibre et le composant (photodiode par exemple) en fournissant un nouveau procédé de couplage. A cet effet la photodiode présente sur une face destinée à être couplée à la fibre optique, au moins une cavité en forme de cuvette, éventuellement hémisphérique, dans laquelle on logera l'extrémité de la fibre optique.

Une telle cavité, présentant sur ses parois une jonction semiconductrice, est réalisable par attaque chimique suivie d'une diffusion d'impuretés dopantes dans une pastille semiconductrice, selon des conditions précisées par le brevet français de la demanderesse publié sous le N° 1.536.424, relatif aux "Perfectionnements aux diodes semiconductrices de structure planar pour hautes fréquences".

La mise en place de l'extrémité de la fibre optique devient alors beaucoup plus facile qu'en l'absence d'une telle cavité. De plus on peut alors éliminer l'ambase classique de la tête opto-électronique et la remplacer par une simple protection en matière plastique traversée par les connexions de raccordement de l'anode et de la cathode de la photodiode.

Une telle cavité est décrite, aussi, dans le facicule de brevet US—A—4 010 483 qui décrit un procédé de couplage comportant les étapes suivantes:

(a) réalisation d'une structure semiconductrice destinée à constituer une diode opto-électronique par la formation ultérieure d'une couche semiconductrice dopée de façon à constituer avec le reste de la structure une jonction redresseuse;

(b) formation d'une cavité par attaque chimique de la structure destinée à être couplée à la fibre optique et à être le siège de la jonction redresseuse, l'attaque chimique étant localisée dans une zone superficielle délimitée par une couche de matériau résistant à l'attaque chimique;

(c) formation de la jonction redresseuse par dopage du matériau semiconducteur constituant la paroi interne de la cavité;

(d) réalisation d'une tête opto-électronique par mise en place de l'extrémité d'une fibre optique dans la cavité de la structure.

En comparaison de cet état de la technique, le procédé de couplage selon l'invention est principalement caractérisé en ce que:

— la structure semiconductrice de l'étape (a) est formée d'une ou de plusieurs parties présentant toutes le même type de conductivité;

— le matériau de dopage sélectionné au cours de l'étape (c) est de type de conductivité contraire, de façon que la zone superficielle dopée de la cavité constitue, avec le reste de la structure, la jonction redresseuse.

L'invention a donc pour objet un procédé de couplage entre une fibre optique et une diode opto-électronique, comportant les étapes suivantes:

(a) réalisation d'une structure semiconductrice destinée à constituer une diode opto-électronique par la formation ultérieure d'une couche semiconductrice dopée de façon à constituer avec le reste de la structure une jonction redresseuse;

(b) formation d'une cavité par attaque chimique de la structure destinée à être couplée à la fibre optique et à être le siège de la jonction redresseuse, l'attaque chimique étant localisée dans une zone superficielle délimitée par une couche de matériau résistant à l'attaque chimique;

(c) formation de la jonction redresseuse par dopage du matériau semiconducteur constituant la paroi interne de la cavité;

(d) réalisation d'une tête opto-électronique par mise en place de l'extrémité d'une fibre optique dans la cavité de la structure; caractérisé en ce que la structure semiconductrice de l'étape (a) est formée d'une ou de plusieurs parties présentant toutes le même type de conductivité, le matériau de dopage sélectionné au cours de l'étape (c) étant de type conductivité contraire, de façon que la zone superficielle dopée de la cavité constitue, avec le reste de la structure, la jonction redresseuse.

L'invention sera mieux comprise, et d'autres caractéristiques apparaitront, au moyen de la description qui suit, et des dessins qui l'accompagnent, parmi lesquels:

— les figures 1 à 4 représentent en coupe partielle différentes étapes de réalisation du procédé selon l'invention;
— les figures 5 et 6 représentent des variantes
du procédé;
— la figure 7 représente une tête opto-électronique réalisée en utilisant le procédé selon
l'invention.

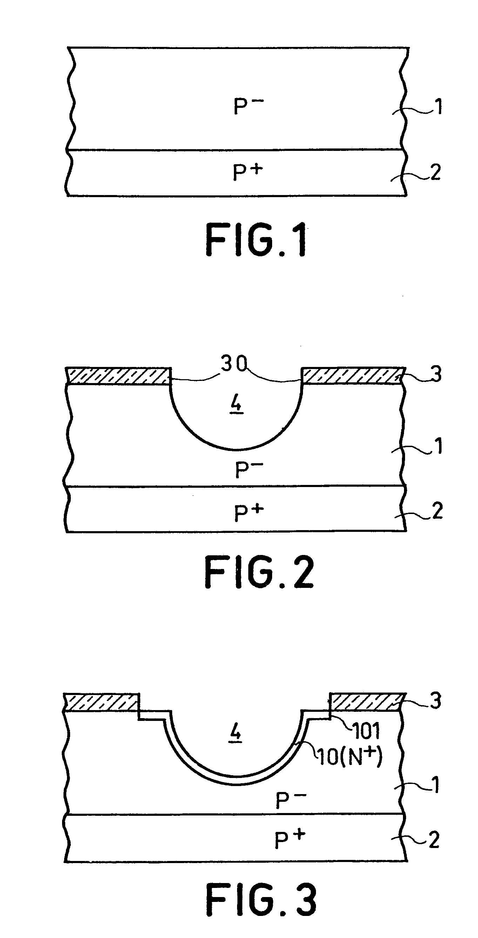

Figure 1, on a représenté en coupe partielle
une pastille semiconductrice comportant par
exemple un substrat 1 dopé $P^-$, et une couche 2
dopée $P^+$. L'épaisseur de substrat est largement supérieure au diamètre de la fibre optique
destinée à être couplée à la structure semiconductrice après la réalisation, dans cette structure, d'une diode, par exemple photodétectrice.
La réalisation d'une telle structure, par des
moyens classiques, constitue l'étape (a) du
procédé.

Figure 2, on a représenté la même pastille
après attaque chimique effectuée sur la face du
substrat 1 opposée à la couche 2. Cette face
avait été préalablement recouverte par une
couche de silice 3, déposée par exemple par
pulvérisation cathodique. Une fenêtre 30 avait
également été aménagée dans la couche 3 par
un moyen classique tel qu'un dépôt de résine
éliminé ensuite à l'aide d'un solvant. Ces étapes
préliminaires de l'étape (b), du procédé selon
l'invention ne sont pas représentées.

Au cours de l'étape (b) proprement dit,
l'attaque chimique est effectuée par exemple en
utilisant un agent rapide, par exemple un
mélange d'acide fluorhydrique et d'acide
nitrique dans le cas d'un substrat en silicium. On
obtient alors une cavité 4 en forme de calotte
sphérique.

Au cours de l'étape (c) du procédé, on
effectue le dopage, par une impureté de type N,
de la pastille semiconductrice préalablement
protégée sur les faces autres que celle de la
couche 3. Le dopage est poursuivi jusqu'à
l'obtention d'un taux élevé ($N^+$) dans une
couche 19 comme il est classique dans les
diodes photodétectrices du type de l'exemple
considéré, et cela pour améliorer la quantité du
contact de raccordement électrique de la diode.
La couche 3 a été préalablement éliminée sur le
bord de la cavité 4 de façon à aménager une
zone dopée 101. Cette opération peut se faire
par attaque chimique sélective après protection
du reste de la couche 3.

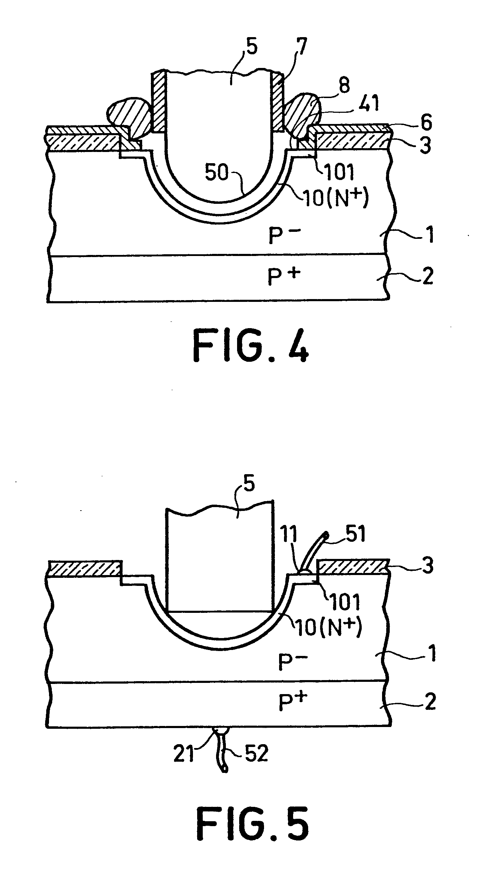

A l'étape (d) du procédé, on introduit l'extrémité 50 d'une fibre optique 5 dans la cavité 4
(figure 4). A titre d'exemple, pour améliorer le
couplage optique entre fibre et diode, on a préalablement arrondi la partie 50 par un des procédés maintenant classiques, telle qu'une fusion
de l'extrémité de la fibre optique ou l'apport de
verre en fusion.

Dans la réalisation représenté à titre
d'exemple, figure 4, la diode a été métallisée,
après attaque chimique de la couche 3 pour mettre préalablement à nu le bord 41 de la
cavité 4. Le dépôt métallique 6 est effectué en
ménageant une épargne sur une partie au moins
du bord 41. La figure 4 représente en outre
partiellement une fibre optique 5 dont l'extrémité est recouverte d'une métallisation 7. Les
métallisations 6 et 7 peuvent ensuite être raccordées électriquement en utilisant un cordon
de soudure annulaire 8. La polarisation de la
diode peut alors être effectuée en se raccordant à la partie métallisée de la fibre optique, ce
qui peut être avantageux pour certains modèles
de tête opto-électronique.

Dans une première variante simplifiée de
l'invention, représentée figure 5, on se contente de mettre en place une fibre optique 5
sans lui faire subir aucun traitement ayant pour
but d'arrondir l'extrémité à coupler à la diode ou
à métalliser une partie de la fibre. Des connexions 51 et 52 sont soudées respectivement
à des contacts 11 et 21 aménagés sur la zone
101 de la couche $N^+$ et sur la couche $P^+$.

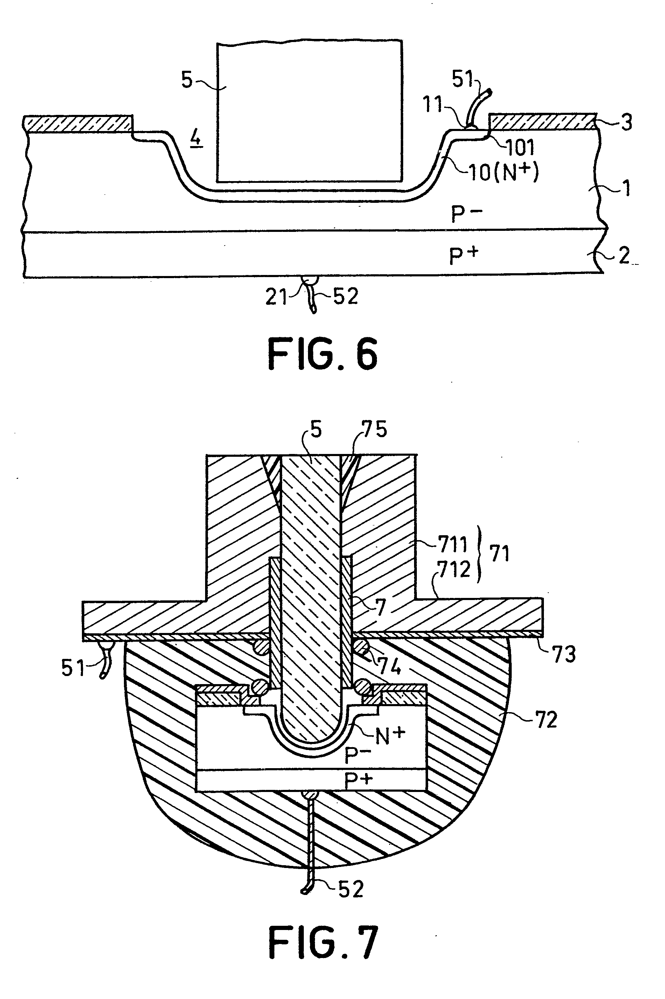

Dans une deuxième variante simplifiée,
représentée figure 6, on utilise, pour créer la
cavité 4, un agent chimique d'attaque lente.
Dans ces conditions, on obtient une cavité à
fond plat. Le couplage de la diode avec une fibre
optique terminée par une section droite, comme
dans la première variante, est alors meilleur que
dans le cas d'une cavité en calotte sphérique.
Les connexions sont réalisées de la même façon
que dans la première variante.

Le procédé selon l'invention permet de
réaliser une tête opto-électronique plus simple
et de volume plus réduit que les têtes
classiques.

En prenant comme point de départ la réalisation représentée figure 4, il suffit, pour obtenir
une telle tête, d'adjoindre au dispositif de départ
un porte-fibre 71 et un enrobage 72 par
exemple en résine synthétique. La connexion 51
(couche $N^+$) est reliée à la métallisation 7 de la
fibre optique 5 grâce à l'adjonction d'une métallisation 73 sur la face de l'embase 712 du
porte-fibre, côté diode. Un cordon de soudure
74 relie les métallisations 7 et 73. L'embout
711 du porte-fibre comporte une perforation
centrale 75 assez large pour permettre l'immobilisation de la fibre optique par la colle ou de la
résine. Il est à noter que, dans un but de clarification, le dessin de la figure 7 n'est pas à
l'échelle. En effet, le diamètre de la fibre optique
étant de l'ordre du dixième de millimètre,
l'embout 711 et l'embase 712 ont par exemple
des diamètres respectifs de 3 et de 20 mm.
Quant au contact avec la couche $P^+$, il est raccordé par une connexion 52 qui traverse
l'enrobage 72.

L'invention est applicable aux diodes électroluminescentes comme aux diodes photodétectrices mises en place dans les équipements terminaux de liaisons optiques à petite et
à moyenne distances.

## Revendications

1. Procédé de couplage entre une fibre optique et une diode opto-électronique, comportant les étapes suivantes:

(a) réalisation d'une structure semiconductrice destinée à constituer une diode opto-électronique par la formation ultérieure d'une couche semiconductrice dopée de façon à constituer avec le reste de la structure une jonction redresseuse;

(b) formation d'une cavité (4) par attaque chimique de la structure destinée à être couplée à la fibre optique et à être le siège de la jonction redresseuse, l'attaque chimique étant localisée dans une zone superficielle délimitée par une couche de matériau résistant à l'attaque chimique;

(c) formation de la jonction redresseuse par dopage du matériau semiconducteur constituant la paroi interne de la cavité;

(d) réalisation d'une tête opto-électronique par mise en place de l'extrémité d'une fibre optique (5) dans la cavité (4) de la structure; caractérisé en ce que la structure semiconductrice de l'étape (a) est formée d'une ou de plusieurs parties présentant toutes le même type de conductivité, et en ce que le matériau de dopage sélectionné au cours de l'étape (c) est de type conductivité contraire, de façon que la zone superficielle dopée de la cavité constitue, avec le reste de la structure, la jonction redresseuse.

2. Procédé suivant la revendication 1, caractérisé en ce qu'il comporte une étape supplémentaire, située entre les étapes (c) et (d) constituant à arrondir l'extrémité de la fibre optique destinée à être mise en palce dans la cavité.

3. Procédé suivant l'une quelconque des revendications 1 et 2, caractérisé en ce qu'à l'étape (b), l'attaque chimique est effectuée en utilisant un agent à action rapide, de façon à obtenir une cavité en forme de calotte sphérique.

4. Procédé suivant l'une quelconque des revendications 1 et 2, caractérisé en ce qu'à l'étape (b), l'attaque chimique est effectuée en utilisant un agent à action lente, de façon à obtenir une cavité à fond plat.

5. Procédé suivant l'une des revendications 1 à 4, caractérisé en ce qu'à l'étape (c), an agrandit la zone délimitée par la couche de matériau résistant à l'attaque chimique de l'étape précédente, en éliminant ce matériau en bordure de la cavité.

6. Procédé suivant la revendication 5, caractérisé en ce qu'une première métallisation (6) est déposée au bord de la cavité, et une deuxième métallisation (7) est déposée sur une partie de la fibre située au voisinage du point de couplage avec la diode, en épargnant l'extrémité proprement dite de la fibre, et en ce qu'on effectue une soudure raccordant les deux métallisations.

7. Tête opto-électronique obtenu par un procédé suivant l'une quelconque des revendications 1 à 5, caractérisée en ce que des connexions de raccordement électrique sont reliées à des contacts établis sur des zones semiconductrices de types opposés de conductivité appartenant à la diode.

8. Tête opto-électronique obtenue par un procédé suivant la revendication 6, caractérisée en ce qu'une première connexion électrique (51) est reliée à la métallisation de la fibre optique, une seconde connexion électrique (52) étant reliée à la diode.

9. Tête opto-électronique suivant la revendication 8, caractérisée en ce qu'elle comporte un porte-fibre (71) et un enrobage (72) entourant la diode.

10. Tête opto-électronique suivant la revendication 9, caractérisée en ce que le porte-fibre comporte une embase métallisée (712) en contact avec la métallisation (7) de la fibre optique, la première connexion électrique (51) étant reliée à cette métallisation (7) par l'intermédiaire de l'embase.

## Patentansprüche

1. Verfahren zur Kopplung zwischen einer optischen Faser und einer optoelektronischen Diode, mit folgenden Verfahrensschritten:

(a) Schaffung einer Halbleiterstruktur, die dazu bestimmt ist, eine optoelektronische Diode zu bilden, indem anschließend eine dergestalt dotierte Halbleiterschicht gebildet wird, daß mit dem übrigen Teil der Struktur ein Gleichrichterübergang gebildet wird;

(b) Bildung eines Hohlraumes (4) durch Ätzen der Struktur, die dazu bestimmt ist, an die optische Faser angekoppelt zu werden und den Ort des Gleichrichterüberganges zu bilden, wobei die chemische Ätzung in einer Oberflächenzone lokalisiert ist, die durch eine Schicht aus einem Material, das der chemischen Ätzung widersteht, begrenzt ist;

(c) Bildung des Gleichrichterüberganges durch Dotierung des Halbleitermaterials, welches die Innenwand des Hohlraumes bildet;

(d) Schaffung eines optoelektronischen Kopfstückes durch Anbringen des Endes einer optischen Faser (5) in dem Hohlraum (4) der Struktur; dadurch gekennzeichnet, daß die Halbleiterstruktur im Verfahrensschritt (a) aus einem oder mehreren Teilen gebildet ist, die alle von demselben Leitungstyp sind, und daß das im Verfahrensschritt (c) gewählte Dotiermaterial vom entgegengesetzten Leitungstyp ist, so daß die dotierte Oberflächenzone des Hohlraumes mit dem Rest der Struktur den Gleichrichterübergang bildet.

2. Verfahren nach Anspruch 1, dadurch gekennzeichnet, daß es einen weiteren Verfahrensschritt umfaßt, der zwischen den Schritten (c) und (d) liegt und darin besteht, daß das Ende der optischen Faser abgerundet wird, das dazu bestimmt ist, in den Hohlraum eingebracht zu werden.

3. Verfahren nach einem der Ansprüche 1 und 2, dadurch gekennzeichnet, daß im Schritt (b) das chemische Ätzen durchgeführt wird, indem ein Mittel schneller Wirkung verwendet wird, so daß ein Hohlraum in Form einer Kugelschale gebildet wird.

4. Verfahren nach einem der Ansprüche 1 und 2, dadurch gekennzeichnet, daß im Schritt (b) das chemische Ätzen durchgeführt wird, indem ein Mittel langsamer Wirkung verwendet wird, so daß ein Hohlraum mit flachem Boden erhalten wird.

5. Verfahren nach einem der Ansprüche 1 bis 4, dadurch gekennzeichnet, daß im Schritt (c) die Zone vergrössert wird, die durch die dem chemischen Ätzen beim vorausgehenden Schritt widerstehende Materialschicht begrenzt ist, indem dieses Material am Rand des Hohlraumes entfernt wird.

6. Verfahren nach Anspruch 5, dadurch gekennzeichnet, daß eine erste Metallisierung (6) auf dem Rand des Hohlraumes aufgebracht wird und eine zweite Metallisierung (7) auf einem Teil der Faser in der Nähe des Koppelpunktes mit der Diode aufgebracht wird, wobei das eigentliche Ende der Faser freigelassen wird, und daß eine die beiden Metallisierungen verbindende Lötung vorgenommen wird.

7. Optoelektronisches Kopfstück, das durch ein Verfahren nach einem der Ansprüche 1 bis 5 erhalten wird, dadurch gekennzeichnet, daß elektrische Anschlußverbindungen mit Kontakten verbunden werden, die an Halbleiterzonen entgegengesetzten Leitungstyps, die zu der Diode gehören, gebildet sind.

8. Kopfstück, das durch eine Verfahren nach Anspruch 6 erhalten wird, dadurch gekennzeichnet, daß ein erster elektrischer Anschluß (51) mit der Metallisierung der optischen Faser verbunden ist und ein zweiter elektrischer Anschluß (52) mit der Diode verbunden ist.

9. Optoelektronisches Kopfstück nach Anspruch 8, dadurch gekennzeichnet, daß es eine Faserfassung (71) und eine die Diode umgebende Umhüllung (72) umfaßt.

10. Optoelektronisches Kopfstück nach Anspruch 9, dadurch gekennzeichnet, daß die Faserfassung einen metallisierten Sockel (712) umfaßt, der mit der Metallisierung (7) der optischen Faser in Berührung ist, wobei der erste elektrische Anschluß (51) mit dieser Metalisierung (7) über den Sockel verbunden ist.

## Claims

1. Method of coupling between an optic fibre and an opto-electronic diode, comprising the following steps:

(a) producing a semiconductor structure susceptible of forming an opto-electronic diode by subsequent forming of a semiconductor layer doped in a manner to form a rectifier junction with the remainder of the structure;

(b) forming a cavity (4) by chemical attack of the structure susceptible of being coupled to the optic fibre and of being the site of the rectifier junction, the chemical attack being localised in a superficial zone defined by a layer of a material resisting against the chemical attack;

(c) forming the rectifier junction by doping the semiconductor material forming the inner wall of the cavity;

(d) forming an opto-electronic head by placing the end of an optic fibre (5) into the cavity (4) of the structure;

characterized in that the semiconductor structure of step (a) is formed of one or a plurality of portions all having the same conductivity type, and in that the doping material selected in step (c) is of opposite conductivity type, so that the doped superficial zone of the cavity forms the rectifier junction with the remainder of the structure.

2. Method in accordance with claim 1, characterized in that it comprises an additional step between steps (c) and (d) consisting in rounding the end of the optic fibre susceptible of being placed within the cavity.

3. Method in accordance with any of claims 1 and 2, characterized in that the chemical attack in step (b) is performed using an agent having rapid action, in a manner to obtain a cavity of spherical dome shape.

4. Method in accordance with any of claims 1 and 2, characterized in that the chemical attack of step (b) is performed using an agent having slow action, in a manner to obtain a cavity having a flat bottom.

5. Method in accordance with any of claims 1 to 4, characterized in that the zone defined by the layer of a material resisting against the chemical attack of the preceding step is enlarged in step (c) by elimination of this material at the border of the cavity.

6. Method in accordance with claim 5, characterized in that a first metallizing (6) is deposited on the border of the cavity and a second metallizing (7) is deposited on part of the fibre located in the neighborhood of the coupling point with the diode, while leaving the actual end of the fibre, and in that the two metallizings are connected by soldering.

7. Opto-electronic head obtained by a method in accordance with any of claims 1 to 5, characterized in that electric connection terminals are connected to contacts formed on the semiconductor zones of opposed conductivity type belonging to the diode.

8. Opto-electronic head obtained by a method in accordance with claim 6, characterized in that a first electric terminal (51) is connected to the metallizing of the optic fibre, a second electric terminal (52) being connected to the diode.

9. Opto-electronic head in accordance with claim 8, characterized in that it comprises a fibre support (71) and an envelope (72) surrounding the diode.

10. Opto-electronic head in accordance with claim 9, characterized in that the fibre support comprises a metallized base (712) contacting the metallizing (7) of the optic fibre, the first electric terminal (51) being connected to this metallizing (7) through the base.

FIG.1

FIG.2

FIG.3

FIG. 4

FIG. 5

FIG. 6

FIG. 7